Europäisches Patentamt

European Patent Office

Office européen des brevets

(11) Veröffentlichungsnummer: **0 046 482**
**B1**

(12) **EUROPÄISCHE PATENTSCHRIFT**

(45) Veröffentlichungstag der Patentschrift: **10.09.86**

(51) Int. Cl.⁴: **G 05 F 1/46**

(21) Anmeldenummer: **81103171.5**

(22) Anmeldetag: **28.04.81**

(54) Schaltung zum Angleichen der Signalverzögerungszeiten von untereinander verbundenen Halbleiterchips.

(30) Priorität: **16.05.80 US 150762**

(43) Veröffentlichungstag der Anmeldung:
**03.03.82 Patentblatt 82/09**

(45) Bekanntmachung des Hinweises auf die Patenterteilung:
**10.09.86 Patentblatt 86/37**

(84) Benannte Vertragsstaaten:
**DE FR GB IT**

(56) Entgegenhaltungen:
**IEEE INTERNATIONAL SOLID-STATE CIRCUITS CONFERENCE, Digest of Technical Papers, Band 19, Nr. 19, 18. Februar 1976, Seiten 56-57 New York, U.S.A. E.M. BLASER et al.: "Substrate and load gate voltage compensation"**

**IBM TECHNICAL DISCLOSURE BULLETIN, Band 17, Nr. 10, März 1975, Seiten 2913-2914 New York, U.S.A. J.A. PARISI et al.: "Speed normalization of logic circuits"**

(73) Patentinhaber: **International Business Machines Corporation**
**Old Orchard Road**
**Armonk, N.Y. 10504 (US)**

(72) Erfinder: **Berndlmaier, Erich**
**37 Edgehill Drive**
**Wappinger Falls New York 12590 (US)**
Erfinder: **Dorler, Jack Arther**
**26 Dose Road**
**Wappinger Falls New York 12590 (US)**
Erfinder: **Mosley, Joseph Michael**
**1 Gene Court**
**Hopewell Junction New York 12533 (US)**
Erfinder: **Weitzel, Stephen Douglas**
**10 North Drive**
**Poughkeepsie New York 12603 (US)**

(74) Vertreter: **Neuland, Johannes, Dipl.-Ing. et al**
**Schönaicher Strasse 220**
**D-7030 Böblingen (DE)**

(56) References cited:
**IBM TECHNICAL DISCLOSURE BULLETIN, Band 18, Nr. 4, September 1975, Seiten 1220-1222 New York, U.S.A. R.C. JAEGER: "Regulated power supply for MTL integrated circuits"**

EP 0 046 482 B1

Courier Press, Leamington Spa, England.

## Beschreibung

Die Erfindung bezieht sich auf eine Schaltung zum Angleichen der Signalverzögerungszeiten von eine Vielzahl von Logikgattern enthaltender Halbleiterchips, deren jeder eine Regelschaltung aufweist zum Ändern seiner Signalverzögerungszeit über die ihm zugeführte elektrische Leistung aufgrund eines Vergleichs der Signalverzögerungszeit von auf dem Halbleiterchip erzeugten periodischen Impulsen mit dem sehr genau definierten Intervall von dem Halbleiterchip zugeführten Taktimpulsen.

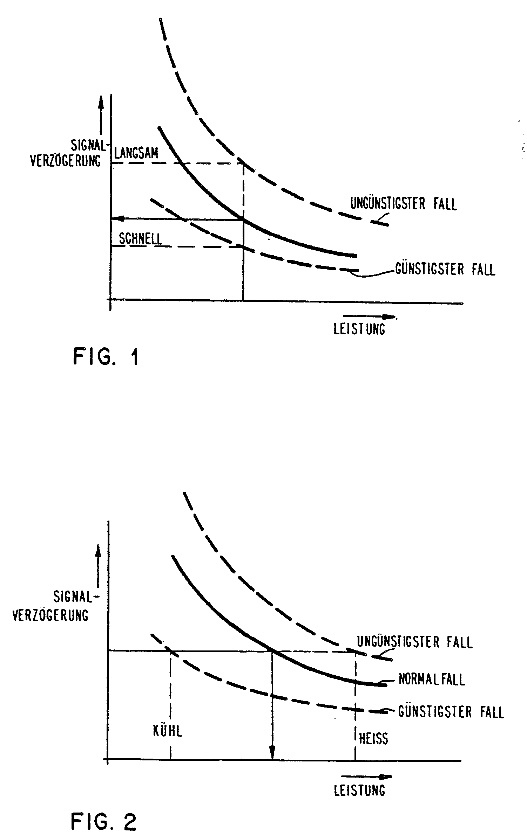

Das gegenwärtige Verfahren des Schaltkreisentwurfs besteht darin, logische Schaltungen und regelmäßige Anordnungen aus ihnen zu entwerfen, die bei einem bestimmten Leistungspegel arbeiten. Es gibt zahlreiche Lehren im Stand der Technik, um einen bestimmten Leistungspegel oder einen bestimmten Strompegel innerhalb eines logischen Gatters aufrechtzuerhalten. Insbesondere sind in der Technologie der Stromübernahmeschalter Zusatzschaltungen auf einem Halbleiterchip vorgesehen, um die Änderungen im Strompegel innerhalb des logischen Gatters zu minimieren, während die Temperatur, die Versorgungsspannungen und auch die Einflüsse des Herstellungsprozesses von Los zu Los variieren. Fig. 1 zeigt eine typische Kurve der Signalverzögerung in Abhängigkeit von der Verlustleistung mit einem Pfeil, der die gegenwärtige Entwurfspraxis zeigt — Wählen eines Verlustleistungspegels, Aufrechterhalten dieses Verlustleistungspegels und Annehmen der daraus resultierenden Signalverzögerung. Beim Entwurf wird versucht, die Änderungen im betrieblichen Verhalten unter einer Reihe von Bedingungen zu minimieren. Die Kurve der Signalverzögerung eines Gatters als Funktion der Leistung in Fig. 1 kann in jeder Richtung sich bewegen und sogar ihre Neigung ändern. Gleichzeitig weist die Regelschaltung für die Verlustleistung ihre eigenen Störungen auf. Diese resultieren in einer weiten Streuung der Schaltgeschwindigkeiten der logischen Gatter.

Fig. 2 zeigt eine Kurve der Gatter-Signalverzögerung als Funktion der Verlustleistung und dient dazu, das bevorzugte Entwurfsverfahren gemäß der Erfindung zu illustrieren. Die Schaltgeschwindigkeit oder Signalverzögerung des logischen Gatters wird gewählt und die Verlustleistung innerhalb der Schaltung wird so eingestellt, daß diese Schaltgeschwindigkeit erreicht wird. Dies wird zustandegebracht durch Entwerfen von auf dem Halbleiterchip befindlichen Schaltungen, die empfindlich sind für die bei Ausgleichsvorgängen geltenden Leistungskennwerte der auf dem Chip befindlichen logischen Schaltungen oder Matrixanordnungen. Diese spezielle Schaltung (Regler für die Signalverzögerung) erzeugt ein Signal, das das Verhalten des Halbleiterchips anzeigt (Schaltgeschwindigkeit als Funktion der Leistung), das verglichen wird mit einem für das ganze System verwendeten periodischen Bezugs- oder Taktsignal. Der Vergleich erzeugt ein Signal, das die den logischen und/oder Matrixschaltungen auf dem Halbleiterchip zugeführte elektrische Leistung regelt und damit das Betriebsverhalten. (Nämlich den Punkt auf der Kurve, die die Gatter-Signalverzögerung als Funktion der Leistung angibt, der einer festgesetzten Gatter-Signalverzögerung entspricht). Durch Zuführen des Bezugssignals zu allen Halbleiterchips in dem System weisen alle diese Chips das gleiche relative Betriebsverhalten auf, d. h. die gleiche Gatter-Signalverzögerung oder Schaltgeschwindigkeit. Da ein kontinuierlicher Vergleich zwischen dem Bezugssignal und dem auf dem Halbleiterchip erzeugten Signal vorgenommen wird, werden viele Variable, die das betriebliche Verhalten beeinflussen, wie z. B. die Stromversorgung, Temperaturänderungen, Schwankungen bei der Fertigung der einzelnen Chips usw. minimiert oder eliminiert.

Aus US—A— Re 29 619 ist ein Digital-Analog-Umsetzer bekannt, dessen Ausgangsschaltung einen Satz von Schalttransistoren aufweist, die als Stromgeneratoren angeordnet sind. Die Ströme durch die Schalttransistoren werden konstant gehalten mittels einer Schaltung, die die Versorgungsspannung entsprechend einstellt und einen gesonderten Bezugstransistor enthält, der mit einem der Schalttransistoren übereinstimmt und an die gleichen Spannungsversorgungsleitungen angeschlossen ist wie die Schalttransistoren. Die Regelschaltung für die Versorgungsspannung enthält einen Operationsverstärker, der den Kollektorstrom des Bezugstransistors abfühlt und die Versorgungsspannung so einstellt, daß der Kollektorstrom konstant bleibt. Dieses automatische Einstellen der Versorgungsspannung hält auch den Strom durch die Schalttransistoren konstant.

In US—A—3 602 799 ist eine hochstabile und schnell schaltende, einen Gleichstrom liefernde Stromquelle offenbart zur Erzeugung einer genauen Bezugsspannung für die Verwendung in anderen Geräten wie beispielsweise in sehr schnell arbeitenden Analog-Digital-Umsetzern. Ein kontinuierlicher, konstanter Laststrom wird selektiv zwischen zwei Stromwegen umgeschaltet, von denen der eine eine Ausgangslast enthält, an der die genannte Bezugsspannung erzeugt wird. Eine digital gesteuerte, sehr schnell arbeitende Treiberschaltung mit einer Differenzverstärkerkonfiguration steuert das Fließen des konstanten Stromes wahlweise durch eine von zwei Schottky-Dioden. Die Dioden dienen als elektronische Schalter der Konstant-Stromquelle, welche einen Operationsverstärker enthält, der in einer Rückkopplungsschleife angeordnet ist, die eine Darlington-Transistorkonfiguration enthält und gesteuert wird durch eine von außen zugeführte Eingangsbezugsspannung und ein Fehlersignal, das durch das Fließen des Laststromes über einem temperaturkompensierten Widerstand erzeugt wird.

In US—A—3 743 850 ist eine integrierte Stromversorgungsschaltung beschrieben, bei der Gleichströme zur Arbeitspunkteinstellung für eine monolithisch integrierte Schaltung von einer geregelten Bezugsstromquelle erhalten werden, die Strom durch erste und zweite in Reihe geschaltete Dioden liefert, um Punkte mit Bezugspotential herzustellen. Einige der Transistoren der Stromquelle, die mit dieser geregelten Stromquelle verbunden sind, sind mit ihren Basis-Emitterstrecken an die erste Diode angeschlossen, und der Emitterstrom dieser Transistoren der Stromquelle wird gesammelt und dem Strom der geregelten Spannungsquelle hinzugefügt und durchfließt die zweite Diode. Diese zweite Diode, durch die ein größerer geregelter Strom fließt, wird benutzt, um als Referenz für weitere Stromquellen-Transistoren mit wesentlich größeren Strömen zu dienen, ohne daß es nötig ist, ein hohes Flächenverhältnis für die Emitterflächen dieser Stromquellen-Transistoren festzulegen.

Aus dem US—A—3 754 181 ist eine monolithisch integrierbare Konstantstromquelle für Transistoren bekannt, die als stromstabilisierende Elemente miteinander verbunden sind. Um die Empfindlichkeit für Schwankungen der Versorgungsspannung bei einer monolithisch integrierten Konstantstromquelle mit einer Reihe von Transistoren zu verringern, ist der Steuertransistor durch einen Verstärker ersetzt. Nur ein Bruchteil der Summe der Basisströme der Stromquellen-Transistoren wird dem Eingang des Verstärkers zugeführt. Auch die Anzahl der Stromquellen-Transistoren ist nicht durch den Stromverstärkungsfaktor begrenzt, wie das der Fall ist, wenn ein Steuertransistor benutzt wird.

Eine Stromübernahme-Schaltung ist in dem US—A—3 758 791 beschrieben. Sie besteht aus einem Transistorpaar, bei dem der eine Transistor als Bezugselement und der andere als Eingangselement dient. Die Schaltung enthält ferner zwei Serienschaltungen aus einem Widerstandselement und einer Diode, die jeweils zwischen den betreffenden Kollektoren der beiden Transistoren angeschlossen sind, wobei die Polarität der Dioden entgegengesetzt zueinander ist, so daß die Emitterströme der Transistoren automatisch geregelt werden, um einen vorgegebenen Wert einzuhalten, wodurch die Gleichstrompegel der Ausgangsspannungen der Stromübernahmeschaltung konstant gehalten werden gegenüber temperaturbedingten Schwankungen der Transistorparameter.

Aus US—A—3 778 646 ist eine Halbleiter-Logikschaltung bekannt, die im Strombetrieb arbeitet und zumindest einen Transistor mit geerdetem Emitter enthält, über den eine Betriebsspannungsquelle mit der logischen Schaltung verbunden ist. Der Ausgang der logischen Schaltung wird über eine Rückkopplungsschaltung auf den Transistor mit geerdetem Emitter rückgekoppelt. Als Ergebnis kann die Schwankung am Ausgang der logischen Schaltung auf einem Minimum gehalten werden, auch wenn die Belastung der logischen Schaltung verändert wird.

In US—A—3 794 861 ist die Schaltung eines Bezugsspannungsgenerators offenbart, der besonders geeignet ist für Konstantstromschaltungen, die eine geringe Temperatur- und eine geringe Spannungsempfindlichkeit aufweisen. Die Schaltung besteht aus einer Teilschaltung für die Bezugsspannung, die eine geringe Spannungsempfindlichkeit und eine verhältnismäßig hohe Temperaturempfindlichkeit aufweist und einer zusätzlichen Rückkopplungsschaltung zur Rückführung einer kompensierenden Temperaturempfindlichkeit, um eine geringe Gesamtempfindlichkeit zu erhalten. Die Temperaturempfindlichkeit des Bezugsspannungsgenerators beruht überwiegend auf der Temperaturempfindlichkeit des Spannungsabfalles an einer Basis-Emitterdiode, der selektiv gesteuert oder im wesentlichen durch geeignete Auswahl von Widerständen im Rückkopplungskreis aufgehoben werden kann, so daß eine temperaturempfindliche Komponente rückgekoppelt wird. Das Rückkopplungssignal ist abhängig von der Differenz der Spannungsabfälle in den Basis-Emitterdioden zweier Transistoren, die verschieden große Ströme leiten und wird in ähnlicher Weise verstärkt, um tatsächlich das Aufheben der Empfindlichkeit des Bezugsspannungsgenerators zu erlauben.

Aus US—A—3 803 471 ist eine Steuerschaltung zur Impulsbreitenmodulation bekannt, die einen Leistungsschalter aufweist, der keine externe Vorrichtung zum Stromausgleich benötigt. Die Schaltung besitzt eine Reihe parallel geschalteter Leistungstransistoren, deren Übertragungsverhältnis für den Strom in Vorwärtsrichtung abrupt abnimmt bei Anwachsen des Kollektorstromes und deren Basisspannung von einem einen konstanten Strom abgebenden Schaltregler geliefert wird, der eine Reihe von parallel geschalteten Klemm-Transistoren aufweist, die parallel zu den Ausgangsklemmen des Reglers geschaltet sind und durch Impulse variabler Breite eingeschaltet werden, um Strom von den Leistungstransistoren abzuleiten und dadurch den Leistungsschalter aus- und einzuschalten. Der Ausgang des Reglers ist mit der Basis jedes Leistungstransistors über eine Diode gekoppelt, deren Spannungsabfall in Vorwärtsrichtung das Teilen des Basisstromes unterstützt und einen mehrfachen Transistorausfall verhindert.

In US—A—3 808 468 ist ein Feldeffekt-Bootstrap-Verstärker beschrieben, dessen Gate durch Vorladung eine verhältnismäßig hohe Gatespannung und eine verhältnismäßig niedrige Drainspannung aufweist, die von einer gemeinsamen Versorgungsquelle geliefert wird. Die Gatespannung wird von periodischen Impulsen abgeleitet, die von einem auf dem Halbleiterchip befindlichen freilaufenden FET-Multivibrator und einer Spannungs-Vervielfacherschaltung erzeugt werden, die von der genannten Versorgungsquelle gespeist werden. Die Impulsbreite der periodischen Impulse ändert sich als inverse Funktion der Steilheit der auf dem Halbleiterchip befindlichen Feldeffekttransistoren und als eine direkte Funktion von deren Schwellwertspannung. Die Impulsbreite steuert die Ladezeit eines Zusatzkondensators in der Spannungs-Vervielfacherschaltung, wodurch die Amplitude der Zusatzspannung eine direkte Funktion der Impulsbreite ist. Die Zusatzspannung wird dem Gate des FET-Bootstrap-Verstärkers zugeführt.

Aus US—A—3 978 473 ist ein Digital-Analog-Umsetzer bekannt, der einen als integrierte Schaltung ausgeführten Schaltmodul mit vier Schalttransistoren und zugehöriger Steuerschaltung enthält. Die Emitterflächen der Schalttransistoren sind binär gewichtet, um für gleiche Stromdichten zu sorgen. Ein fünfter Transistor dient als Referenztransistor zum Einstellen der Versorgungsspannung, was notwendig ist, um einen konstanten Strom durch die Schalttransistoren aufrechtzuerhalten. Um einen Digital-Analog-Umsetzer zu konstruieren, der eine hohe Bitauflösung besitzt, kann eine Reihe solcher "Vierer"-Schaltmodule kombiniert werden, z. B. in einer Baugruppe aus Schaltkarten, die einen Modul mit Dünnfilmwiderständen einschließt, der binär gewichtete Widerstände auf einem Glassubstrat aufweist, um die Strompegel für die Schalttransistoren einzustellen.

In US—A—4 004 164 ist eine Stromquelle offenbart für die Verwendung auf einem Halbleiterchip mit Feldeffekttransistoren, um die Änderungen der Spannungsquelle für die Substratspannung zu kompensieren. Wenn sich Analogschaltungen allein oder kombiniert mit digitalen Logikschaltungen auf einem Halbleiterchip befinden, sind sie normalerweise empfindlich für Störungen in der Vorspannung, die dem Substrat des Halbleiterchips zugeführt wird. Das Erzielen einer gleichmäßigen Ausgangsleistung einer Analogschaltung aufgrund einer Änderung der Eingangsspannung hat bisher die Verwendung von Präzisionsspannungsquellen außerhalb des Halbleiterchips erfordert. Solche teuren Präzisionsspannungsquellen können eliminiert werden, und es können normale variable Spannungsversorgungen (± 15%) verwendet werden durch Vorsehen einer auf dem Chip befindlichen Kompensationsstromquelle, die eine Einheit mit anderen Schaltungen bildet, um stabile Bezugsspannungspegel auf dem Halbleiterchip zur Verwendung durch die Analogschaltungen zu liefern.

Die Kompensationsschaltung enthält zwei Feldeffekttransistoren vom Verarmungstyp, die in Reihe geschaltet sind zwischen einer Spannungsquelle mit höherer Spannung und der Substratspannung, wobei der Feldeffekttransistor, der an die höhere Spannung angeschlossen ist, mit seinem Gate mit dem gemeinsamen Knoten der beiden Transistoren verbunden ist und sich in Sättigung befindet, während das Gate des an die niedrigere Spannung angeschlossenen Feldeffekttransistors an das Massepotential angeschlossen ist und dieser Transistor im linearen Bereich der Kennlinie arbeitet. Das Gate eines Feldeffekttransistors vom Anreicherungstyp ist mit dem gemeinsamen Knoten der beiden Feldeffekttransistoren vom Verarmungstyp verbunden und seine Source-Elektrode mit dem negativen Pol der Substratspannungsquelle. Durch eine geeignete Auswahl der Parameter fließt durch diese Schaltung ein Strom, der sich umgekehrt zu den Änderungen der Substratvorspannung ändert, um eine kompensierte Stromquelle für die anderen Analogschaltungen zu ergeben. Als Beispiele sind Schaltungen für eine stabilisierte Bezugsspannungsquelle, eine Stromsteuerschaltung für einen Differenzverstärker und eine kombinierte Schaltung gezeigt.

In US—A—4 029 974 ist ein Digital-Analog-Umsetzer offenbart, der aus einer Reihe von Stromquellen-Transistoren gebildet wird, die so angeordnet sind, daß sie verschiedene Strompegel führen, entsprechend einem vorgegebenen Gewichtsmuster, d. h. einem binären Gewichtsmuster. In dem Umsetzer führen eine Reihe von Stromquellen-Transistoren gleicher Größe die verschiedenen Strompegel und arbeiten daher bei verschiedenen Stromdichten mit verschiedenen Basis-Emitterspannungen, abhängig von der Temperaturdrift. Stabile Emitterspannungen, die für genaue Pegel des gewichteten Stromes sorgen, werden erzeugt durch Widerstände zwischen den Basen aufeinanderfolgender Stromquellen-Transistoren und einer Stromquelle, um an den Widerständen zwischen den Basen eine Spannung zu erzeugen, die sich linear mit der absoluten Temperatur ändert, entsprechend der Differenz zwischen den Basis-Emitterspannungen aufeinanderfolgender Stromquellen-Transistoren.

Die Schaltung zur Erzeugung eines sich linear mit der absoluten Temperatur ändernden Stromes wird gebildet aus ersten und zweiten Transistoren, die gezwungen werden, den gleichen Strom bei verschiedenen Stromdichten zu führen, um verschiedene Basis-Emitterspannungen zu erzeugen und durch Mittel wie einen Emitterwiderstand, der auf die Differenz der Basis-Emitterspannungen anspricht, um einen Strom zu erzeugen, der Differenz der Basis-Emitterspannungen entspricht und sich linear mit der Temperatur ändert.

Aus US—A—4 100 431 ist eine Schnittstellenschaltung bekannt zur Verbindung eines Teils einer integrierten Schaltung, der als integrierte Injektionslogik ($I^2L$) ausgeführt ist, mit einem linearen Teil der integrierten Schaltung. Die Schaltung überträgt sowohl logische Information als auch $I^2L$-Bezugsstrompegel von der $I^2L$-Schaltung zu der linearen Schaltung bei relativ hohen Spannungspegeln, die in der linearen Schaltung vorhanden sind. Ein Ausführungsbeispiel verwendet eine Kaskode-Anordnung mit einem Transistor, zwei Dioden und einem Widerstand. Ein anderes Ausführungsbeispiel nutzt die sich gleichenden Eigenschaften eines Transistorpaares aus, das in Vorwärts- und im Umkehrbetrieb arbeitet, um die Funktion mit nur einem Transistor auszuführen.

In US—A—4 145 621 ist eine Logikschaltung aus Transistoren offenbart, die eine Konstantstromquelle in der Form einer Stromspiegelschaltung enthält, die mit einer Kombination eines logischen Gatters aus Schalttransistoren verbunden ist, wobei die Anordnung derart ist, daß die Schalttransistoren nicht sättigen.

In US—A—4 160 934 wird der Strom durch eine Halbleiter-Leuchtdiode, der von einem Feldeffekttransistorschalter mit isoliertem Gate geliefert wird, durch eine Stromsteuerschaltung stabilisiert, die ein als Vergleicher dienendes Rückkopplungsnetzwerk enthält, das die Spannung an dem Knoten zwischen dem genannten Schalter und der Serienverbindung eines Ballastwiderstandes und der Leuchtdiode stabilisiert.

Aus US—A—4 172 992 ist es bekannt, ein Transistorpaar mit verschiedenen Stromdichten zu betreiben, um ein diffentielles Basis-Emitterpotential zu erzeugen. Dieses Potential dient als Referenz in einer gegengekoppelten Stabilisierungsschaltung, die einen Strom abgibt, der durch das Potential geregelt wird. Die Schaltung kann auch Ströme regeln, die in einer Reihe von zusätzlichen Stromquellen und Senken, die damit verbunden sind, fließen.

In US—A—3 736 477 ist die grundlegende I²L-Struktur und Schaltung offenbart.

Bezüglich des Standes der Technik wird noch auf folgende weiteren Veröffentlichungen aus dem IBM Technical Disclosure Bulletin verwiesen:

(1) "Current Source Generator" von G. Keller et al., Vol. 12, No. 11, April 1970, Seite 2031;

(2) "Precision Integrated Current Source" von A. Cabiedes et al., Vol. 13, No. 6, November 1970, Seite 1699;

(3) "Voltage Reference Buffer" von J. A. Dorler et al., Vol. 14, No. 7, Dezember 1971, Seite 2095;

(4) "Adjustable Underfrequency-Overfrequency Limiting Circuit" von W. B. Nunnery, Vol. 15, No. 6, November 1972, Seiten 1927—9;

(5) "Reference Voltage Generator and OFF-Chip Driver For Current Switch Circuit" von A. Brunin, Vol. 21, No. 1, Juni 1978, Seiten 219—20; und

(6) "Gated Current Source" von J. W. Spencer Jr., Vol. 21, No. 7, Dezember 1978, Seiten 2719—20.

Ferner wird bezüglich des Standes der Technik noch auf die folgenden Veröffentlichungen Bezug genommen:

(1) "Integrated Injection Logic Shaping Up As Strong Bipolar Challenge to MOS", Electronic Design 6, 15. März 1974, Seiten 28 und 30 und

(2) "I²L Puts It All Together For 10-bit A-D Converter Chip" von Paul Brokaw, Electronics, 13. April 1978, Seiten 99—105.

(3) "Substrate and load gate voltage compensation" von E. M. Blaser et al, IEEE International Solid-State Circuits Conference, Digest of Technical Papers, Band 19, Nr. 19, 18. Februar 1976, Seiten 56—57.

Aus der letzgenannten Veröffentlichung ist eine Schaltung bekannt, die dem Angleichen der Signalverzögerungszeiten von Halbleiterchips dient. Dazu ist auf jedem Halbleiterchip eine Regelschaltung vorgesehen. Jede dieser Regelschaltungen benötigt einen eigenen Taktgenerator, dem zum Erzeugen eines als Bezugsimpuls dienenden Ausgangsimpulses Taktimpulse mit sehr stabiler Frequenz zugeführt werden müssen. Ferner erfordert die bekannte Schaltung eine an den Ausgang des Taktgenerators angeschlossene Verzögerungskette, die aus einer Reihe hinereinandergeschalteter Gatter des Chips gebildet wird. Sie dient der Verzögerung eines ihr zugeführten Impulses, der nach Durchlaufen der Verzögerungskette in einer Vergleichsschaltung mit einem Impuls verglichen wird, der dieser Schaltung direkt zugeleitet wird.

Die Erfindung, wie sie in den Ansprüchen gekennzeichnet ist, löst die Aufgabe, die unterschiedlichen Signalverzögerungszeiten verschiedener Halbleiterchips einander anzugleichen und auf einen gewünschten Wert zu bringen.

Die durch die Erfindung erreichten Vorteile sind im wesentlichen darin zu sehen, daß das Angleichen der unterschiedlichen Signalverzögerungszeiten verschiedener Halbleiterchips dem Konstrukteur eines Systems dessen Entwurf erleichtert, da er für einen bestimmten Gatterpfad nun nicht mehr, wie bisher Halbleiterchips mit größerer und geringerer Schaltgeschwindigkeit zu kombinieren braucht. Außerdem erlaubt das Angleichen der Signalverzögerungszeiten verschiedener Chips die Wahl einer höheren Taktfrequenz für das System, die sich bisher an der größten Signalverzögerungszeit orientieren mußte.

Im folgenden wird die Erfindung in Verbindung mit den Zeichnungen näher erläutert, von denen zeigen:

Fig. 1 eine Kurve, die die Gatter-Signalverzögerung als Funktion der dem Gatter zugeführten elektrischen Leistung darstellt. Die Kurve der Fig. 1 gibt den Zustand nach dem Stand der Technik wieder, bei dem die Leistung festgelegt oder gewählt wird und die Schaltgeschwindigkeit oder die Signalverzögerung der Schaltung der ihr zugeführten Leistung entspricht;

Fig. 2 eine Kurve, die die Gatter-Signalverzögerung als Funktion der Leistung für eine logische Schaltung angibt. Die Kurve nach Fig. 2 ist gemäß der Erfindung dargestellt, nach der die Gatter-Signalverzögerung (oder Schaltgeschwindigkeit) jeder aus einer Reihe von logischen Schaltungen auf einem Halbleiterchip (oder auf Halbleiterchips) fest vorgegeben ist oder beim Schaltungsentwurf festgelegt wurde, und die den logischen Schaltungen zugeführte elektrische Leistung (Strom oder Spannung) entspricht der gewählten oder fest vorgegebenen Schaltgeschwindigkeit;

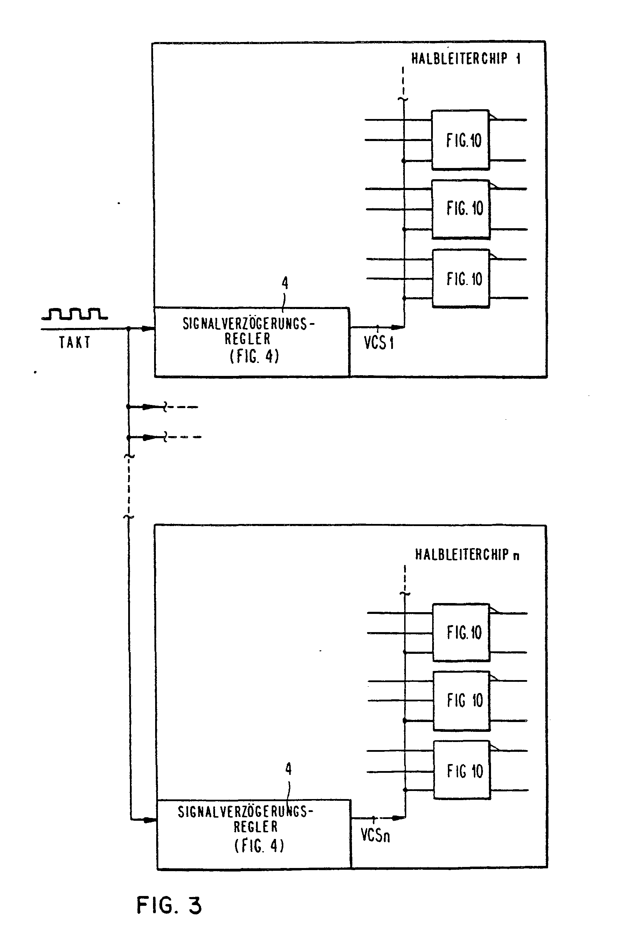

Fig. 3 ein Blockdiagramm gemäß der Erfindung. Eine Reihe von Halbleiterchips 1 bis n mit monolithisch integrierten Schaltungen sind dargestellt. Jedes Halbleiterchip enthält einen Regler für die Signalverzögerung und eine Reihe mit ihm verbundener logischer Schaltkreise. In der Zeichnung sind nur drei logische Schaltkreise dargestellt. Die logischen Schaltkreise sind als Blöcke dargestellt, die die Legende "Fig. 10" tragen. Ebenso sind die Verbindungen zwischen den logischen Schaltkreisen auf jedem Halbleiterchip und zwischen den Halbleiterchips, da sie für das Verständnis der Erfindung nicht notwendig sind, nicht dargestellt. Den Fachleuten ist bekannt, daß jedes der Halbleiterchips Hunderte von miteinander verbundenen logischen Schaltkreisen enthalten kann. Auch ist die Erfindung nicht beschränkt auf logische Schaltkreise der in Fig. 10 dargestellten Art (Stromübernahmeschalter oder emittergekoppelte Logikschaltkreise). Aus der nachfolgenden genaueren Beschreibung ist für den Durchschnittsfachmann ersichtlich, daß die Erfindung angewandt werden kann bei der Transistor-Transistor-Logik (T²L), der Dioden-Transistor-Logik (DTL), der integrierten Injektionslogik (I²L) und anderen Technologiefamilien als auch bei Matrixanordnungen. Aus der Fig. 3 ist zu ersehen, daß der Regler 4 für die Signalverzögerung jedes Halbleiterchips das gleiche Taktsignal empfängt. Jeder dieser Regler für die Signalverzögerung erzeugt intern auf dem Halbleiterchip ein diskretes bestimmtes Bezugssignal, das in Zusammenarbeit mit dem Taktsignal den Regler für die Signalverzögerung veranlaßt, ein eindeutiges Signal VCS zu liefern. Beispielsweise liefert der Regler für die Signalverzögerung des Halbleiterchips 1 (Fig. 3) das Signal VCS1, wogegen der Regler für die Signalverzögerung des Halbleiterchips 2 das Signal VCS2 (nicht dargestellt) liefert und der Regler für die Signalverzögerung des Halbleiterchips n liefert das Signal VCSn. Weiter weisen die Größen der Signale VCS1, VCS2, VCSn nicht notwendigerweise eine feste Beziehung zueinander auf. Die Größe oder die Werte jedes der Potentiale VCS1, VCS2,... bis VCSn diktiert ein Punkt auf der Kurve, die die Gatter-Signalverzögerung als Funktion der Leistung wiedergibt, die diesem Halbleiterchip zugeordnet ist und für die gewünschte Schaltgeschwindigkeit sorgt;

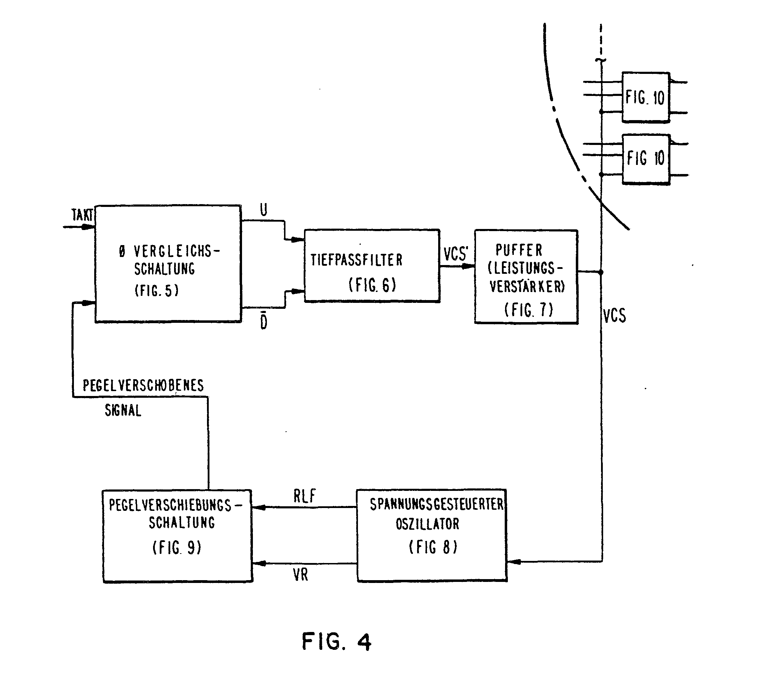

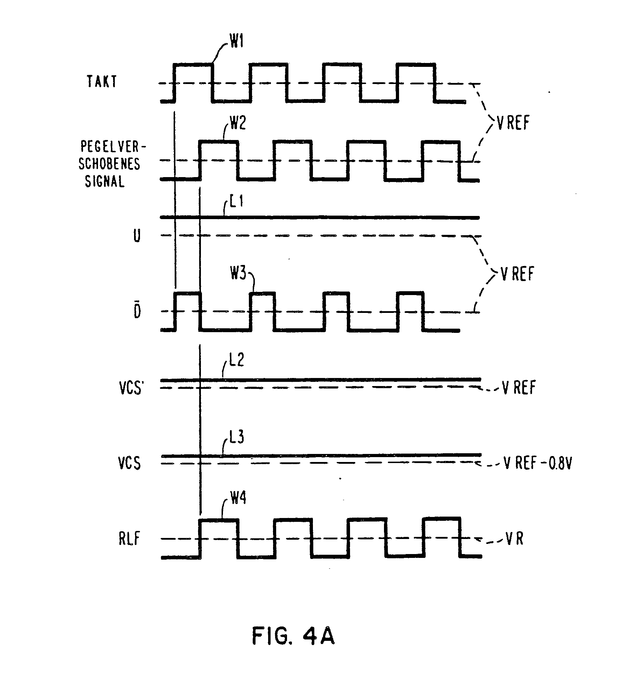

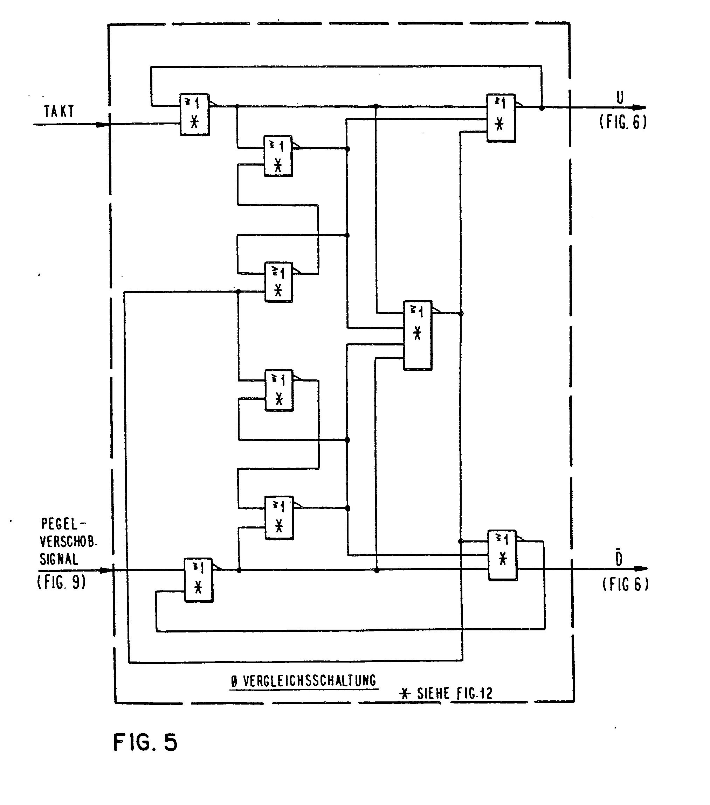

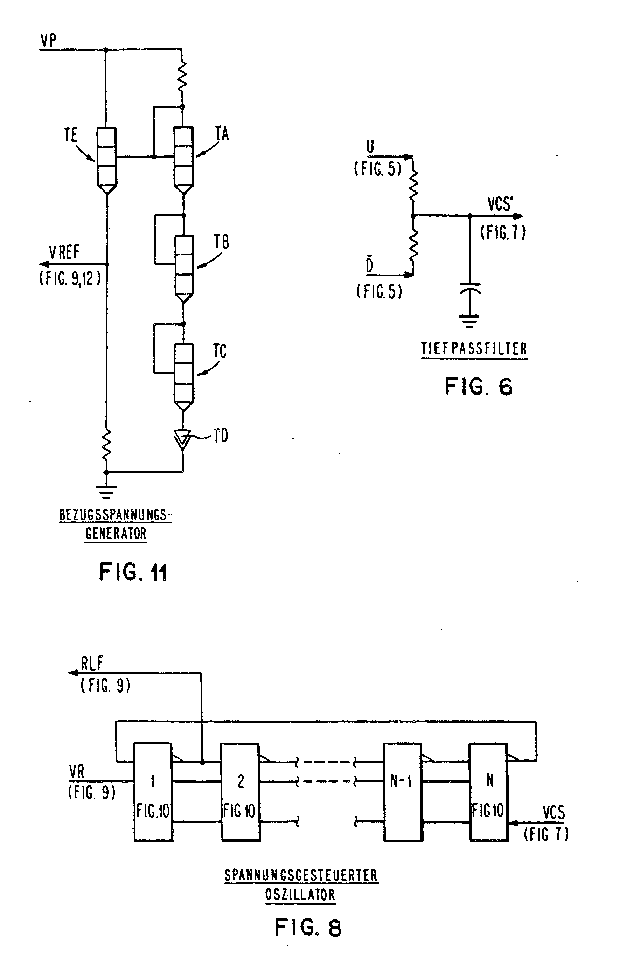

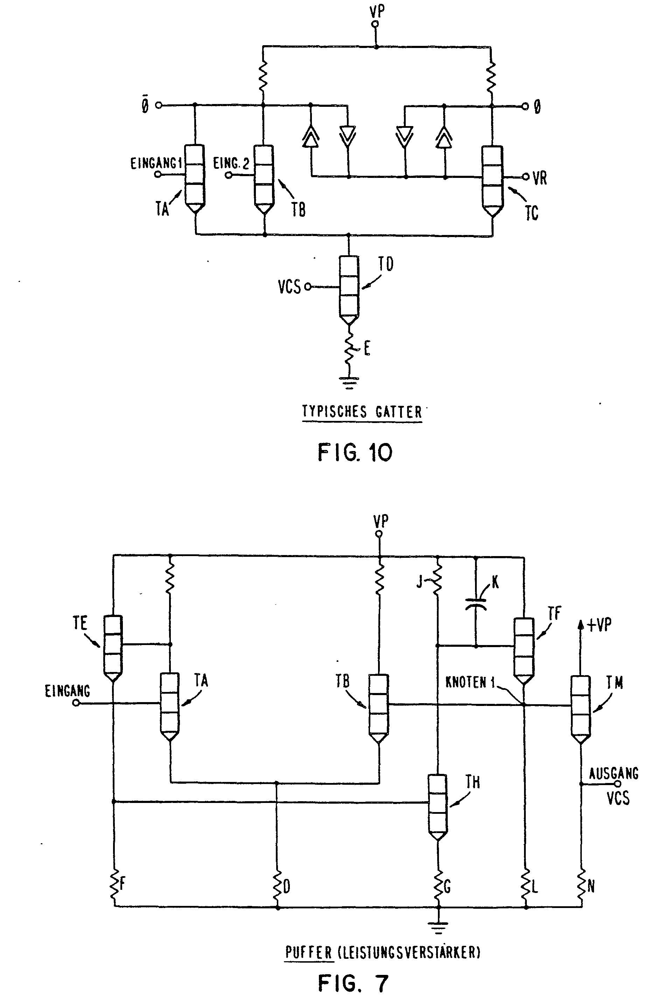

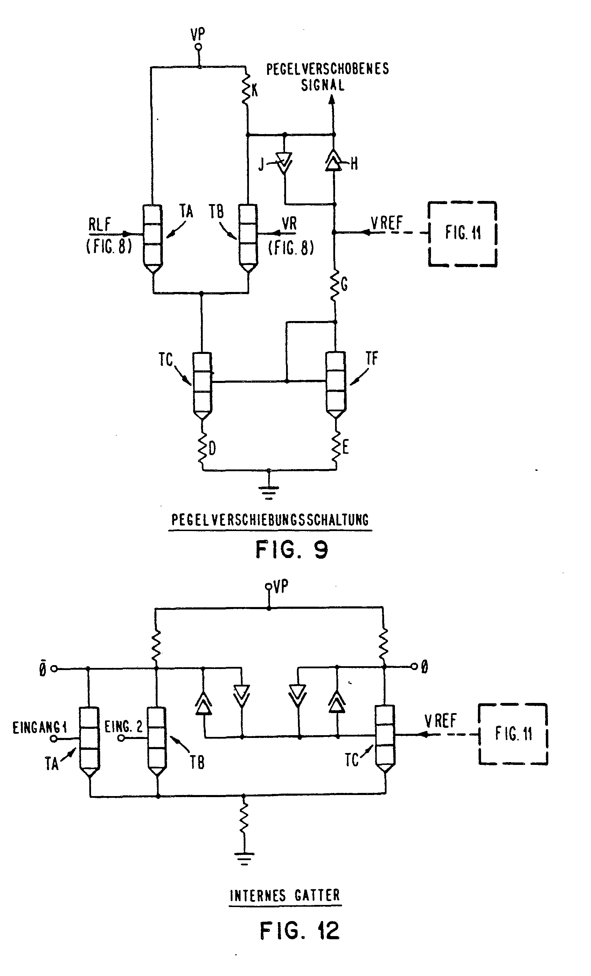

Fig. 4 das Blockdiagramm eines erfindungsgemäßen Reglers für die Signalverzögerung (Vorrichtung zur Leistungsregelung). Aus Fig. 3 ist ersichtlich, daß jedes Halbleiterchip einen Regler für die Signalverzögerung enthält. Die Schaltung des Reglers für die Signalverzögerung kann für jedes Halbleiterchip die gleiche sein. Jeder der Blöcke in Fig. 4 schließt eine Legende und eine Figurenzahl ein. Beispielsweise weist der Phasenkomparatorblock die Legende "Φ Vergleichsschaltung" und "(Fig. 5)" auf, wogegen der spannungsgesteuerte Oszillator die Legende trägt "SGO (RLF)" und "(Fig. 8)". Diese Legenden bedeuten, daß die logische Schaltung der Vergleichsschaltung in Fig. 5 dargestellt ist und die logische Schaltung des spannungsgesteuerten Oszillators in Fig. 8. In dem Ausführungsbeispiel der Erfindung enthält der Regler für die Signalverzögerung eine "Φ Vergleichsschaltung (Fig. 5)", ein "Tiefpaßfilter (Fig. 6)", eine "Pufferschaltung oder einen Leistungsverstärker (Fig. 7)", einen "spannungsgesteuerten Oszillator RLF (Fig. 8)" und eine "Pegelverschiebungsschaltung (Fig. 9)", die so miteinander verbunden sind, wie das in Fig. 4 dargestellt ist. Anstelle des spannungsgesteuerten Oszillators kann auch ein stromgesteuerter Oszillator verwendet werden;

Fig. 4A idealisierte Kurvenverläufe und Potentialpegel, die in Verbindung mit der Erklärung der Wirkungsweise des Reglers für die Signalverzögerung (Fig. 4) zu betrachten sind;

Fig. 5 ein logisches Blockdiagramm einer Phasenvergleichsschaltung, die gemäß der Erfindung in dem Regler für die Signalverzögerung (Fig. 4) benutzt werden kann;

Fig. 6 eine Tiefpaß-Filterschaltung, die gemäß der Erfindung in dem Regler für die Signalverzögerung (Fig. 4) verwendet werden kann;

Fig. 7 eine Pufferschaltung, die gemäß der Erfindung in dem Regler für die Signalverzögerung (Fig. 4) verwendet werden kann. Es sei bemerkt, daß die Pufferschaltung die Funktion eines Leistungsverstärkers erfüllt und auch so bezeichnet werden kann;

Fig. 8 einen spannungsgesteuerten Oszillator (RLF), der gemäß der Erfindung in dem Regler für die Signalverzögerung (Fig. 4) verwendet werden kann. Es sei bemerkt, daß der spannungsgesteuerte Oszillator vorzugsweise eine Reihe von logischen Schaltkreisen verwendet, bei denen die Gatter-Signalverzögerung (oder Schaltgeschwindigkeit) durch den Regler für die Signalverzögerung geregelt werden soll. Bei dem hier offenbarten Ausführungsbeispiel der Erfindung ist der logische Schaltkreis, dessen Gatter-Signalverzögerung (oder Schaltgeschwindigkeit) geregelt werden soll, ein Stromübernahmeschalter (emittergekoppelter Logikschaltkreis) wie er in Fig. 10 dargestellt ist. Der spannungsgesteuerte Oszillator kann die Form einer Umlaufschleife annehmen, wie das in Fig. 8 dargestellt ist, in der die Gesamtanzahl der Inverterstufen ungerade ist;

Fig. 9 eine Pegelverschiebungsschaltung, die gemäß der Erfindung in dem Regler für die Signalverzögerung (Fig. 4) verwendet werden kann;

Fig. 10 einen als Stromübernahmeschalter ausgeführten Logikschaltkreis (emittergekoppelte Logik), dessen Gatter-Signalverzögerung (oder Schaltgeschwindigkeit) gemäß der Erfindung durch den Regler für die Signalverzögerung geregelt wird;

Fig. 11 einen Bezugsspannungsgenerator zur Lieferung einer Bezugsspannung VREF, der von der Pegelverschiebungsschaltung nach Fig. 9 und dem internen Gatterschaltkreis nach Fig. 12 benutzt werden kann;

Fig. 12 einen internen Gatterschaltkreis der Stromübernahme-Schaltkreisfamilie (oder emittergekoppelten Logik), der in der Phasenvergleichsschaltung nach Fig. 5 verwendet werden kann;

Fig. 13 das Blockschaltbild eines spannungsgesteuerten Oszillators (SGO) für die erfindungsgemäße Verwendung in der Leistungsregelvorrichtung eines Systems, in dem die Schaltkreise, deren Signalverzögerung zu regeln oder zu optimieren ist, der technologischen Schaltkreisfamilie der Transistor-Transistor-Logik angehören (, die in Fig. 14 dargestellt ist);

Fig. 14 einen Schaltkreis in Transistor-Transistor-Logik, dessen Signalverzögerung gemäß der Erfindung geregelt oder optimiert wird durch Verwendung einer Vorrichtung zur Leistungssteuerung, die den spannungsgesteuerten Oszillator nach Fig. 13 enthält;

Fig. 15 ein Blockschaltbild eines spannungsgesteuerten Oszillators zur erfindungsgemäßen Verwendung der Vorrichtung zur Leistungssteuerung eines Systems, dessen Schaltkreise, deren Signalverzögerung zu regeln oder zu optimieren ist, der Schaltkreisfamilie angehören, die als integrierte Injektionslogik (I²L) bezeichnet wird und in den Fign. 16 oder 17 dargestellt ist;

Fig. 16 einen I²L-Schaltkreis, dessen Gatter-Signalverzögerung gemäß der Erfindung geregelt oder optimiert werden soll durch Verwendung einer Vorrichtung zur Leistungskontrolle, die den spannungsgesteuerten Oszillator nach Fig. 15 einschließt;

Fig. 17 einen zweiter I²L-Schaltkreis, dessen Gatter-Signalverzögerung gemäß der Erfindung geregelt oder optimiert werden soll durch Verwendung einer Vorrichtung zur Leistungssteuerung, die den spannungsgesteuerten Oszillator nach Fig. 15 einschließt;

Fig. 18 ein Blockdiagramm eines spannungsgesteuerten Oszillators zur erfindungsgemäßen Verwendung in der Vorrichtung zur Leistungssteuerung eines Systems, in dem die Schaltkreise, deren Signalverzögerung zu regeln oder zu optimieren ist, der Schaltkreisfamilie aus Feldeffekttransistoren angehören (von der ein Mitglied in Fig. 19 dargestellt ist);

Fig. 19 einen Feldeffekttransistor-Schaltkreis, dessen Gatter-Signalverzögerung gemäß der Erfindung geregelt oder optimiert werden kann durch Verwendung einer Vorrichtung zur Leistungssteuerung, die den spannungsgesteuerten Oszillator nach Fig. 18 einschließt.

Fig. 1 zeigt eine typische Kurve der Signalverzögerung eines logischen Gatters als Funktion der zugeführten elektrischen Leistung, die alle Logikfamilien aufweisen. Augenblickliche Praxis ist es, ein logisches Gatter bei einem bestimmten Leistungspegel zu betreiben. Dies wird bewiesen durch die vielen Veröffentlichungen von Schaltungen, die entworfen wurden, um einen bestimmten Leistungspegel oder eine bestimmte Stromeinstellung in der Schaltung aus logischen Gattern aufrechtzuerhalten. Der Gedanke, zu versuchen, eine bestimmte Leistung oder Stromeinstellung aufrechtzuerhalten, führt jedoch zu verschiedenen Problemen. Das erste Problem bezieht sich auf die Herstellung der Halbleiterbauelemente. Während des normalen Verlaufs der Herstellung von Halbleiterbauelementen gibt es kleinere Störungen des Herstellungsprozesses. Diese geringfügigen Abweichungen beeinflussen die Lage der Kurve, die die Abhängigkeit der Schaltgeschwindigkeit als Funktion der Leistung darstellt, wie das in Fig. 1 gezeigt ist. Wenn die Kurve sich ändert, ändert sich die Gatter-Signalverzögerung. Das zweite Problem stellen die Hilfsschaltungen dar, die dazu entworfen wurden, um einen bestimmten Leistungs- oder Strompegel in dem logischen Schaltkreis aufrechtzuerhalten. Diese Schaltungen sind ebenfalls Abweichungen beim Herstellungsprozeß unterworfen und sind gleichzeitig in dem System empfindlich für Änderungen der Versorgungsspannungen und für Temperaturänderungen. Das Endergebnis ist ein logisches Gatter, dessen Leistung innerhalb enger Grenzen geregelt wird, aber dessen Signalverzögerung beträchtlich variieren kann.

Fig. 2 zeigt das Verfahren gemäß der Erfindung. Die Gatter-Signalverzögerung wird geregelt, während die Leistung des logischen Gatters variieren darf, so daß, wenn sich die Kurve für die Schaltgeschwindigkeit in Abhängigkeit von der Leistung aufgrund des Herstellungsprozesses, der Temperatur oder der Stromversorgung ändert, die Gatter-Signalverzögerung konstant bleibt, während die Leistung variiert.

Fig. 3 illustriert die Implementierung der Erfindung auf der Systemebene. Das System kann aus n Halbleiterchips bestehen. Auf jedem Halbleiterchip befindet sich eine Regelschaltung für die Signalverzögerung, die die den restlichen Gattern auf dem Halbleiterchip zugeführte Leistung regelt. In diesem Beispiel werden die in Fig. 10 dargestellten logischen Gatter benutzt, die in der Technologie der Stromübernahmeschalter ausgeführt sind. Das Signal VCS dient dazu, die Leistung in dem logischen Gatter durch Regelung der Spannung der Stromquelle zu regeln. Das in Fig. 3 dargestellte Taktsignal gelangt an die Regelschaltung für die Signalverzögerung jedes der n Halbleiterchips. Jedes Taktsignal enthält die Information bezüglich der Schaltgeschwindigkeit oder der zeitlichen Steuerung für die Regelschaltung zur Signalverzögerung. Die Regelschaltung vergleicht dieses Taktsignal mit einem Signal, das von einer auf dem Halbleiterchip befindlichen, die Schaltgeschwindigkeit abfühlenden Schaltung geliefert wird und regelt dann die Leistung in den logischen Gattern auf dem Halbleiterchip so, daß die gleiche Schaltgeschwindigkeit erhalten wird wie sie das Taktsignal vorschreibt. Auf diese Weise ist die Schaltgeschwindigkeit von Halbleiterchip zu Halbleiterchip die gleiche, während die zugeführte Leistung von Halbleiterchip zu Halbleiterchip variiert. Da alle Halbleiterchips in dem System logische Gatter mit der gleichen Schaltgeschwindigkeit aufweisen, braucht der Systemkonstrukteur für einen bestimmten Gatterpfad nicht mehr Halbleiterchips mit geringerer und größerer Schaltgeschwindigkeit vorzusehen. Alle Halbleiterchips haben die gleiche Gatter-Signalverzögerung. Es sei bemerkt, daß als Taktsignal vorzugsweise der Systemtakt dient. Aus der nachfolgenden genaueren Beschreibung ist jedoch ersichtlich, daß das dem Regler für die Signalverzögerung zugeführte Taktsignal auch ein anderes als der Systemtakt sein kann.

Fig. 4 zeigt ein Ausführungsbeispiel für die Regelung der Signalverzögerung. Der Regler für die Signalverzögerung besteht aus der Phasenvergleichsschaltung, dem Tiefpaßfilter, der Pufferschaltung, dem spannungsgesteuerten Oszillator und der Pegelverschiebungsschaltung. Die Phasenvergleichsschaltung vergleicht das dem Halbleiterchip von außen zugeführte Taktsignal mit dem pegelverschobenen Signal des spannungsgesteuerten Oszillators. Die Ausgangssignale U und $\overline{D}$ erzeugen ein Signal, das eine Impulsbreite aufweist, die direkt proportional zur Phasendifferenz des Eingangstaktsignals und des pegelverschobenen Signals des spannungsgesteuerten Oszillators ist. Dieses pulsbreitenempfindliche Signal besitzt die gleiche Frequenz wie das Eingangstaktsignal. Die Signale U und $\overline{D}$ gelangen an das Tiefpaßfilter, das die Trägerfrequenz des Eingangstaktsignals aus diesem Signal entfernt. Das Ausgangssignal VCS' ist eine Gleichspannung, die proportional ist der Impulsbreite des Eingangssignals für das Tiefpaßfilter. Das Signal VCS' gelangt zur Pufferschaltung. Die Pufferschaltung ist ein Verstärker mit dem Verstärkungsfaktor 1. Sie besitzt einen hochohmigen Eingang für das Signal VCS' des Tiefpaßfilters. Die Pufferschaltung besitzt auch einen niederohmigen Ausgang, um das Signal VCS den anderen Gattern auf dem Halbleiterchip und der Schaltung des spannungsgesteuerten Oszillators zuzuführen. Das VCS Signal regelt die Leistung der logischen Gatter auf dem Halbleiterchip. In diesem besonderen Ausführungsbeispiel (siehe Fig. 10) regelt das Signal VCS den Strom durch die Stromquelle des logischen Gatters. Bei zunehmendem Signal VCS nimmt die Leistung in der Schaltung zu, wogegen bei abnehmendem Signal VCS die Leistung in der Schaltung abnimmt. Der spannungsgesteuerte Oszillator erzeugt ein Signal RLF, dessen Frequenz proportional ist dem Eingangssignal VCS. Die Schaltung des spannungsgesteuerten Oszillators sollte die gleiche Abhängigkeit der Schaltgeschwindigkeit von der Leistung aufweisen wie die logischen Gatter im restlichen Teil des Halbleiterchips. Wenn daher das Signal VCS die Signalverzögerung des logischen Gatters ändert, ändert sich auch die Frequenz des spannungsgesteuerten Oszillators. Das Ausgangssignal RLF ist ein periodisches logisches Signal. Das Ausgangssignal VR ist die logische Schwelle, oberhalb derer das Signal RLF sich ändert. Diese beiden Signale gelangen zu der Pegelverschiebungsschaltung, die ein Ausgangssignal erzeugt, das pegelverschobene Signal des spannungsgesteuerten Oszillators, das den gleichen logischen Pegel aufweist wie das Eingangstaktsignal und die gleiche Frequenz wie das Signal RLF. Es ist ersichtlich, daß diese Anordnung von Phasenvergleichsschaltung, Tiefpaßfilter, Pufferschaltung, spannungsgesteuertem Oszillator und Pegelverschiebungsschaltung eine Phasenregelschleife darstellt. Durch Verwendung dieser Phasenregelschleife tendiert der spannungsgesteuerte Oszillator dazu, sich mit dem Eingangstaktsignal zu synchronisieren. Diese Wirkungsweise des Phasenregelkreises tendiert dazu, Schwankungen beim Herstellungsprozeß, Temperaturänderungen und Änderungen in der Spannungsversorgung innerhalb der Fähigkeit des spannungsgesteuerten Oszillators, sich mit dem Taktsignal zu synchronisieren, sich nicht auswirken zu lassen. Wenn der spannungsgesteuerte Oszillator einmal synchronisiert wurde, wurde bei den übrigen logischen Gattern auf dem Halbleiterchip die Leistung geändert, so daß die Gatter-Signalverzögerung nun durch die Frequenz des Eingangstaktsignals geregelt wird. Es ist ersichtlich, daß das Eingangstaktsignal, das jetzt auf der Systemebene allen Halbleiterchips zugeführt wird, die Gatter-Signalverzögerung auf jedem einzelnen Halbleiterchip regelt, unabhängig von der Leistung, die das logische Gatter verbraucht oder von der Temperatur des Halbleiterchips oder von den Prozeßschwankungen, die bei der Herstellung der Halbleiterchips von Los zu Los auftreten.

Es ist auch ersichtlich, daß die Phasenvergleichsschaltung, das Tiefpaßfilter, die Pufferschaltung und die Pegelverschiebungsschaltung sich nicht auf dem Halbleiterchip selbst befinden müssen. Die wichtige Schaltung, die sich auf dem Halbleiterchip befinden muß, ist der spannungsgesteuerte Oszillator, der die Schaltgeschwindigkeit oder Gatter-Signalverzögerung abfühlt, die auf dem Halbleiterchip vorhanden ist. Die anderen vier logischen Schaltungsblöcke (Fign. 5, 6, 7 und 9) können außerhalb des Halbleiterchips auf einem anderen Halbleiterchip vorhanden sein oder auch aus diskreten Komponenten zusammengesetzt sein. Der spannungsgesteuerte Oszillator jedoch muß auf dem gleichen Halbleiterchip vorhanden sein wie die zu regelnden logischen Gatter.

Fig. 5 zeigt ein logisches Blockdiagramm der Phasenvergleichsschaltung. In diesem Beispiel sind die logischen Gatter aus den Schaltungen nach Fig. 12 zusammengesetzt. Die Funktion dieser logischen Schaltung ist es, die Phase der beiden Eingangssignale, des dem Halbleiterchip extern zugeführten Systemtaktes und des pegelverschobenen Signals des spannungsgesteuerten Oszillators zu vergleichen und ein logisches Signal an den Ausgängen U und $\overline{D}$ zu erzeugen, daß die gleiche Frequenz wie die Eingangssignale und eine Impulsbreite aufweist, die proportional ist zur Phasendifferenz der beiden Eingangssignale.

Fig. 6 zeigt das Schaltbild des Tiefpaßfilters. Die beiden Eingangssignale U und $\overline{D}$ werden addiert und gefiltert, um die Trägerfrequenz zu entfernen. Das Ausgangssignal VCS' ist ein Gleichstromsignal. Die Grenzfrequenz des Tiefpaßfilters ist so gewählt, daß die Welligkeit des Signals VCS' minimal wird und gleichzeitig die Stabilität des Phasenregelkreises aufrechterhalten wird.

Fig. 11 zeigt einen Bezugsspannungsgenerator. Die Spannung wird durch die Bauelemente TA, TB, TC und TD erzeugt. Das Bauelement TE wird dazu benutzt, um die Bezugsspannung VREF den anderen Schaltungen zuzuführen. Die Bezugsspannung dieser Schaltung dient als ein logischer Schwellwert für die logischen Gatter nach Fig. 12 und für die Phasenvergleichsschaltung nach

Fig. 5. Die Bezugspannung VREF wird auch von der Pegelverschiebungsschaltung nach Fig. 9 benutzt. Diese Spannung dient als Bezugsspannung für die logischen Signale.

Fig. 8 zeigt die Schaltung des spannungsgesteuerten Oszillators. Sie besteht aus N logischen Gattern, die einzeln in Fig. 10 dargestellt sind und in einer Schleifenanordnung miteinander verbunden sind, wobei der Ausgang des Gatters 1 zum Eingang des Gatters 2 führt und dies sich so fortsetzt bis zum Gatter N, dessen Ausgang auf den Eingang des Gatters 1 rückgeführt ist. Diese Schaltung schwingt bei einer Frequenz, die abhängig ist von der Gatter-Signalverzögerung der N Elemente. Die tatsächliche Gatter-Signalverzögerung jedes Elementes wird durch das Signal VCS geregelt. Es ist ersichtlich, daß das Signal VCS die Leistung jedes Gatters ändert. Jede Änderung in der Gatter-Signalverzögerung resultiert in einer Änderung der Frequenz des Signals RLF. Wenn das Signal VCS zunimmt, nimmt auch die Frequenz des Signals RLF zu, und wenn das Signal VCS abnimmt, nimmt auch die Frequenz des Signals RLF ab. Das Ausgangssignal RLF dieser Schaltung gelangt zur Pegelverschiebungsschaltung. Das Signal VR ist das logische Bezugssignal der Gatter in dieser Schleife.

Fig. 9 zeigt die Pegelverschiebungsschaltung. Ihr Zweck ist es, den logischen Pegel des Signals RLF so zu ändern, daß Signale erhalten werden, die mit dem in Fig. 4A dargestellten, außerhalb des Halbleiterchips erzeugten Taktsignal verträglich sind. Das Signal RLF ändert sich zwischen den Spannungspegeln oberhalb des Signales VR und unterhalb dieses Signals. Die Elemente TA, TB, TC und TD bilden eine logische Gatterkonfiguration, bei der der Strom durch das Element TC entweder durch das Element TA oder durch das Element TB fließt, abhängig von der Eingangsspannung RLF. Das Signal VREF, das von der Schaltung nach Fig. 11 abgeleitet wird, dient zwei Funktionen. Die erste Funktion besteht darin, einen Bezugsstrom für die Stromquellenelemente TC und TD zu erzeugen. Diese Bezugsstrom wird erzeugt unter Benutzung der Elemente G, TF und E und den Elementen TC und D der Stromquelle zugeführt unter Benutzung einer Stromspiegelkonfiguration, der Verbindung zwischen TF und TC.

Die zweite Funktion der Spannung VREF besteht darin, das pegelverschobene Ausgangssignal des spannungsgesteuerten Oszillators unter Benutzung der Dioden J und H festzuklemmen, so daß das Ausgangssignal entweder um den Spannungsabfall an einer Diode über der Spannung VREF liegt oder um den Spannungsabfall an einer Diode unter dieser Spannung. Die Wirkungsweise der Schaltung nach Fig. 9 wird durch das Eingangssignal RLF gesteuert. Wenn die Spannung des Eingangssignals über der Spannung VR liegt, fließt der Strom durch das Element TC durch das Element TA. Der Strom durch das Element K fließt durch das Element J, was für das pegelverschobene Signal des spannungsgesteuerten Oszillators eine Spannung erzeugt, die um den Spannungsabfall an der Diode größer als das Signal VREF ist. Wenn das Signal RLF unter der Spannung VR liegt, fließt der Strom durch das Element TC durch das Element TB, wodurch der gesamte Strom durch das Element K durch das Element TB fließt und auch Strom von dem Signal VREF durch das Element H gezogen wird. Dies erzeugt ein Signal mit niedrigem Pegel, das um den Spannungsabfall an einer Diode unter der Spannung VREF liegt, an dem Ausgang für das pegelverschobene Signal des spannungsgesteuerten Oszillators. Es ist ersichtlich, daß die Wirkungsweise dieser Schaltung darin besteht, die Bezugsspannung des logischen Eingangssignals RLF auf den Wert der Bezugsspannung VREF zu verschieben. Das Ausgangssignal hat die gleiche Frequenz wie das Signal RLF, aber besitzt einen davon verschiedenen logischen Pegel.

Fig. 12 zeigt das Schaltbild eines internen Gatters, das in der Phasenvergleichsschaltung nach Fig. 5 verwendet wird. Die Wirkungsweise dieses Gatters ist ähnlich der eines Gatters, das in Stromübernahme-Technologie ausgeführt ist. Die Bezugsspannung VREF wird durch die Schaltung nach Fig. 11 erzeugt. Die Ausgangsspannungen sind festgeklemmte Pegel, die entweder um den Spannungsabfall an einer Diode über oder unter dem Signal VREF liegen. Die Schaltung nach Fig. 12 ist nur mit zwei Eingangstransistoren TA und TB dargestellt, aber andere zusätzliche Transistoren können in der gleichen Weise angeschlossen werden, um ein logisches Gatter mit drei oder vier Eingängen zu bilden. Eine Spannung am Eingang 1 oder am Eingang 2, die über der Eingangsbezugsspannung VREF liegt, leitet den Strom durch diesen Transistor und zieht das Ausgangspotential Φ um den Spannungsabfall an einer Diode unter die Spannung VREF. Die Ausgangsspannung Φ ist um den Spannungsabfall an einer Diode höher als die Spannung VREF. Wenn die Spannungen an den Eingängen 1 und 2 beide kleiner als die Spannung VREF sind, fließt der Strom durch das Element TC und zieht das Signal am Ausgang Φ der Diode unter den Wert VREF. Die Ausgangssignale in der Schaltung werden durch Dioden festgeklemmt, um die richtigen Spannungen zur Steuerung des restlichen Teiles der in Fig. 4 dargestellten Phasenregelschaltung zu liefern.

Fig. 10 ist das Schaltbild eines typischen logischen Gatters, das sowohl in dem spannungsgesteuerten Oszillator (Fig. 8) als auch in den logischen Gattern im Rest des Halbleiterchips verwendet wird, wie das in Fig. 4 angedeutet ist. Die Elemente TD und E bilden eine Stromquelle, die durch ein Signal VCS gesteuert wird. Das Signal VCS steuert daher direkt die Leistung innerhalb des logischen Gatters und damit seine Schaltgeschwindigkeit. Das logische Gatter ist mit zwei Eingängen dargestellt, den Transistoren TA und TB, aber es können zusätzliche Transistoren für weitere Eingänge vorgesehen sein, die in der gleichen Weise angeschlossen sind. Die Aus-

gänge $\overline{\Phi}$ und $\Phi$ sind über Dioden an das Signal VR geklemmt, so daß die Ausgangsspannungen entweder um den Spannungsabfall an einer Diode über oder unter dem Signal VR liegen. Die Eingangsspannungen 1 und 2 der Schaltung liegen entweder über dem Signal VR oder darunter, so daß, wenn entweder das Eingangssignal 1 oder das Eingangssignal 2 über der Spannung VR liegt, der Strom durch das Element TD über den leitenden Transistor fließt. Die Ausgangsspannung $\overline{\Phi}$ liegt dann um den Spannungsabfall an einer Diode unter der Spannung VR. Wenn weder die Eingangsspannung 1 noch die Eingangsspannung 2 über der Spannung VR liegen, dann liegt die Ausgangsspannung $\overline{\Phi}$ um einen Diodenspannungsabfall über den Spannung VR. In ähnlicher Weise fließt der Strom durch das Element TD dann, wenn beide Eingangssignale 1 und 2 unter der Spannung VR liegen, durch das Element TC, so daß das Signal $\Phi$ um einen Diodenspannungsabfall unter der Spannung VR liegt. Wenn beide Eingänge 1 und 2 das hohe Potential aufweisen, dann ist die Ausgangsspannung $\Phi$ um einen Diodenspannungsabfall niedriger als die Spannung VR. Das Signal VR wird allen logischen Gattern auf dem Halbleiterchip zugeführt, die durch den Regler für die Signalverzögerung geregelt werden, einschließlich derjenigen logischen Gatter des spannungsgesteuerten Oszillators nach Fig. 8, so daß alle diese logische Gatter die gleiche Schwellwertspannung verwenden.

Die Schaltung nach Fig. 7 ist eine Pufferschaltung. Sie stellt eine hohe Eingangsimpedanz für das Signal VCS' dar und eine niedrige Ausgangsimpedanz für das Signal VCS, so daß dieses Signal über das gesamte Halbleiterchip zu allen logischen Gattern geführt werden kann, wie das in Fig. 4 dargestellt ist. Die Schaltung ist ein Differenzverstärker, der einen Verstärkungsfaktor von 1 besitzt. Die Elemente TA, TB und D bilden die Differenz-Eingangsstufe der Schaltung. Das Eingangssignal VCS' wird unter Verwendung der Elemente TA, TB und D mit dem Signal am Knoten 1 verglichen. Die Elemente TE, TF, G, TH, J und K sorgen für die notwendigen Signalbedingungen, so daß das Signal am Knoten 1 identisch ist mit dem Eingangssignal VCS'. Die Elemente TM und N sorgen für zusätzliche Ausgangspufferung und Spannungsverschiebung, um ein Signal VCS zu liefern, das den logischen Gattern und dem spannungsgesteuerten Oszillator zugeführt wird, wie das in Fig. 4 dargestellt ist.

Fig. 4A zeigt eine Reihe von Kurvenverläufen und Potentialpegeln, die in Verbindung mit der Erklärung der Wirkungsweise des Reglers für die Signalverzögerung nach Fig. 4 zu betrachten sind. Die Eingangssignale für die Phasenvergleichsschaltung nach Fig. 4 sind der Kurvenverlauf W1 (Takt) und der Kurvenverlauf W2 (pegelverschobenes Signal des spannungsgesteuerten Oszillators). Wie aus Fig. 4A hervorgeht, weist jede dieser Kurvenverläufe einen Teil jeder Impulsperiode auf, in dem der Spannungsverlauf größer ist als die Spannung VREF und einen Teil, in dem der Pegel niedriger ist als die Spannung VREF. Aus den Kurvenverläufen W1 und W2 der Fig. 4A geht auch hervor, daß die Kurvenverläufe W1 und W2 die gleiche Periodizität oder Impulsfolgefrequenz aufweisen. Jedoch eilt der Kurvenverlauf W1 der Taktimpulse in der Phase dem pegelverschobenen Kurvenverlauf W2 des spannungsgesteuerten Oszillators voraus. Das Ausgangssignal U der Phasenvergleichsschaltung ist ein zeitlich konstanter Pegel, der in Fig. 4A mit L1 bezeichnet ist. Es sei bemerkt, daß die Größe von L1 größer ist als von VREF. Weiter ist aus Fig. 4A zu ersehen, daß das Ausgangssignal $\overline{D}$ der Kurvenverlauf W3 ist. Der Kurvenverlauf W3 ist ein periodischer Impulszug, der eine Impulsfolgefrequenz aufweist, die gleich derjenigen des Kurvenverlaufes W1 ist. Es ist auch ersichtlich, daß die Dauer der Impulse im Kurvenverlauf W3 gleich oder direkt proportional zur Phasendifferenz zwischen den Kurvenverläufen W1 und W1 ist. Wie aus Fig. 4A zu ersehen ist, ist das Signal VCS' ein zeitlich konstanter Gleichspannungspegel L2. Die Größe L2 des Signals VCS' ist eine Funktion des durchschnittlichen Potentials der Signale U (L1) und $\overline{D}$ (Kurvenverlauf W3) und der Impulsdauer des Kurvenverlaufs W3. Wie aus der früheren Erklärung der Funktion der Pufferschaltung (Fig. 7) hervorgeht, hat das Signal VCS eine Größe L3, die um die Basis-Emitterspannung eines Transistors unter der Größe L2 des Signals VCS' liegt. Aus Fig. 4A geht auch hervor, daß die Größe L2 des Signals VCS' um einen Zuwachs, z. B. $\Delta$, über der Größe der Spannung VREF, und daß das Signal VCS, dessen Pegel um eine Gleichspannung von 0,8 bis 1 Volt verschoben wurde, auch um den Zuwachs $\Delta$ über der Spannung VREF — 0,8 Volt liegt. Der Kurvenverlauf W4 stellt einen periodischen Impulszug dar, der dem Signal RLF der Fign. 4 und 8 entspricht. Auch die Größe der Spannung VR ist dargestellt. Aus der Fig. 4A ist ersichtlich, daß der Kurvenverlauf W2 (pegelverschobenes Signal des spannungsgesteuerten Oszillators) und der Kurvenverlauf W4 (RLF) einander in der Periodizität und der Impulsdauer entsprechen. Wie aus Fig. 4 hervorgeht, wird der Kurvenverlauf W4 (RLF) durch die Pegelverschiebungsschaltung (Fig. 9) verschoben und wird zu dem pegelverschobenen Signal des spannungsgesteuerten Oszillators, das das Ausgangssignal der Pegelverschiebungsschaltung nach Fig. 4 ist.

Wie früher erklärt wurde, ist zu bemerken, daß das Signal VCS (L3) das Ausgangssignal der Pufferschaltung des Reglers für die Signalverzögerung nach Fig. 4 ist. Dieses Ausgangssignal VCS wird erfindungsgemäß dazu benutzt, den Punkt auf der Kurve, die die Gatter-Signalverzögerung als Funktion der Leistung wiedergibt, zu bestimmen, bei dem die logischen Schaltungen arbeiten. Daher ist diese Größe bestimmend für die konstante Schaltgeschwindigkeit oder Gatter-Signalverzögerung der logischen Schaltungen, die das Signal VCS empfangen.

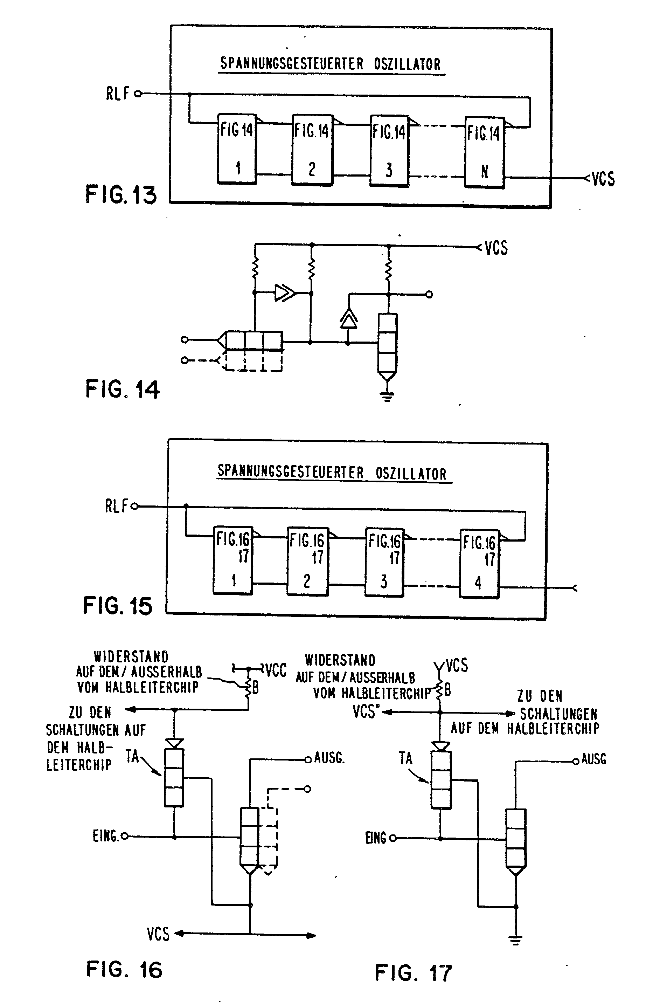

Fig. 13 zeigt die Schaltung des verwendeten spannungsgesteuerten Oszillators, der in Transistor-Transistor-Logik aufgebaut ist. Das Eingangssignal VCS der Schaltung steuert die Leistung in jedem logischen Gatter (Fig. 14). Wie früher erklärt, resultiert das Ändern der Leistung in den logischen Gattern des spannungsgesteuerten Oszillators in einer Frequenzänderung des Signals RLF. Die Implementierung durch Transistor-Transistor-Logik kann bei diesem bevorzugten Ausführungsbeispiel die Pegelverschiebungsschaltung (Fig. 9) für das Ändern der Spannungspegel des Signals RLF entbehrlich machen. Wenn keine Pegelverschiebungsschaltung benötigt wird, was ein Fachmann leicht feststellen kann, ersetzt das Signal RLF das pegelverschobene Signal des spannungsgesteuerten Oszillators als Eingangssignal für die Φ Phasenvergleichsschaltung (Fig. 5). Ebenso würden das Signal VR und das pegelverschobene Signal des spannungsgesteuerten Oszillators von der Schaltung entfernt, da sie nicht länger erforderlich sind. Wenn jedoch durch den Fachmann festgestellt wird, das eine Pegelverschiebungsschaltung benötigt wird, kann es sein, daß die neue Pegelverschiebungsschaltung das Signal VR nicht erfordert, um ein pegelverschobenes Signal des spannungsgesteuerten Oszillators zu erzeugen, das mit der Φ Vergleichsschaltung verträglich ist. Fachleuten ist auch bekannt, daß das Benutzen von Transistor-Transistor-Logik oder irgendeiner anderen Logik in der Φ Vergleichsschaltung Zusatzschaltungen erfordern kann, damit die Signale U und $\overline{D}$ (Fig. 4) als Signale mit den richtigen Quellenimpedanzen und/oder Spannungs/Strompegeln und/oder Temperaturgängen erscheinen und damit Korrekturen der Stromversorgung erfolgen können, damit die Regelschaltung (Fig. 4) für die Signalverzögerung richtig arbeitet.

Fig. 4 ist ein Beispiel eines Gatters in Transistor-Transistor-Logik, das in dem spannungsgesteuerten Oszillator nach Fig. 13 verwendet werden kann. Andere bekannte Konfigurationen von Transistor-Transistor-Logik können ebenfalls verwendet werden. Das von der Pufferschaltung oder dem Leistungsverstärker (Fig. 7) erzeugte Signal VCS gelangt an alle Logik-Gatter des spannungsgesteuerten Oszillators (Fig. 13) und zu den Logik-Gattern im nicht dargestellten restlichen Teil des Halbleiterchips, der die Φ Vergleichsschaltung (Fig. 5) enthalten kann oder nicht. Das Steuersignal VCS ändert die Leistung in dem logischen Gatter (Fig. 14). Wenn das Signal VCS zunimmt, nimmt die dem logischen Gatter zugeführte Leistung zu, was in einer Abnahme der Gatter-Signalverzögerung resultiert. In der gleichen Weise nimmt, wenn das Signal VCS abnimmt, die dem Logik-Gatter zugeführte Leistung ab, was ein Zunehmen der Gatter-Signalverzögerung zur Folge hat. Den Fachleuten ist klar, daß der Spannungspegel des Signals VCS nur bis zu dem Pegel erhöht werden soll, bei dem ein weiteres Zunehmen des Spannungspegels zu keiner weiteren Abnahme der Gatter-Signalverzögerung führt.

Fig. 15 zeigt den benutzten spannungsgesteuerten Oszillator in der Konfiguration der integrierten Injektionslogik (I²L). Das Eingangssignal für die Schaltung, bei dem Logik-Gatter nach Fig. 16 das Signal VCS oder bei dem Logik-Gatter nach Fig. 17 das Signal VCS'', steuert die Leistung in jedem Logik-Gatter. Wie vorher erklärt wurde, hat eine Änderung der Leistung in den Logik-Gattern des spannungsgesteuerten Oszillators eine Frequenzänderung des Signales RLF zur Folge. Wie das vorher bei der Beschreibung der Verwendung von Transistor-Transistor-Logik in dem spannungsgesteuerten Oszillator diskutiert wurde, ist die Pegelverschiebungsschaltung erforderlich oder nicht, das pegelverschobene Signal des spannungsgesteuerten Oszillators und/oder das Signal VR können erforderlich sein oder nicht, und zusätzliche Schaltungen für das richtige Arbeiten des Reglers der Signalverzögerung (Fig. 4) können nötig sein oder nicht.

In den Fign. 16 und 17 sind zwei Beispiele für die Steuerung der Leistung eines I²L-Gatters dargestellt. Fig. 16 zeigt, daß der Strom durch das Element TA gesteuert wird durch eine variable Spannung VCS. Die Spannung VCC besitzt einen festen Wert, so daß, wenn die Spannung des Signals VCS abnimmt, die dem Logik-Gatter zugeführte Leistung zunimmt und dadurch die Signalverzögerung des Logik-Gatters abnimmt. Wenn die Spannung des Signals VCS zunimmt, nimmt die dem Logik-Gatter zugeführte Leistung ab, was wiederum die Signalverzögerung des logischen Gatters vergrößert. Für die Fachleute ist ersichtlich, daß zum Erzielen der richtigen Arbeitsweise der Reglerschaltung für die Signalverzögerung (Fig. 4) die Signale U und $\overline{D}$, die von der Φ Vergleichsschaltung (Fig. 5) erzeugt werden, logisch invertiert werden müssen ($\overline{U}$ und D).

Fig. 17 zeigt ein I²L-Gatter, das durch eine Spannungsänderung über das Element B gesteuert wird. Die Basis des Elementes TA ist mit Masse verbunden, so daß, wenn das Signal VCS sich ändert, der Strom durch das Element TA sich ändert. Wenn die Spannung des Signals VCS zunimmt, nimmt die Leistung in dem Logik-Gatter zu und seine Signalverzögerung ab. Wenn die Spannung des Signals VCS abnimmt, nimmt auch die dem Logik-Gatter zugeführte Leistung ab und damit seine Signalverzögerung zu. Es sei bemerkt, daß für diese spezielle Logik-Gatter die Spannung VCS nicht zum spannungsgesteuerten Oszillator und den restlichen Logik-Gattern auf dem Halbleiterchip verteilt wird. Stattdessen wird das Signal VCS'' zu dem spannungsgesteuerten Oszillator und den restlichen Logik-Gattern auf dem Halbleiterchip verteilt.

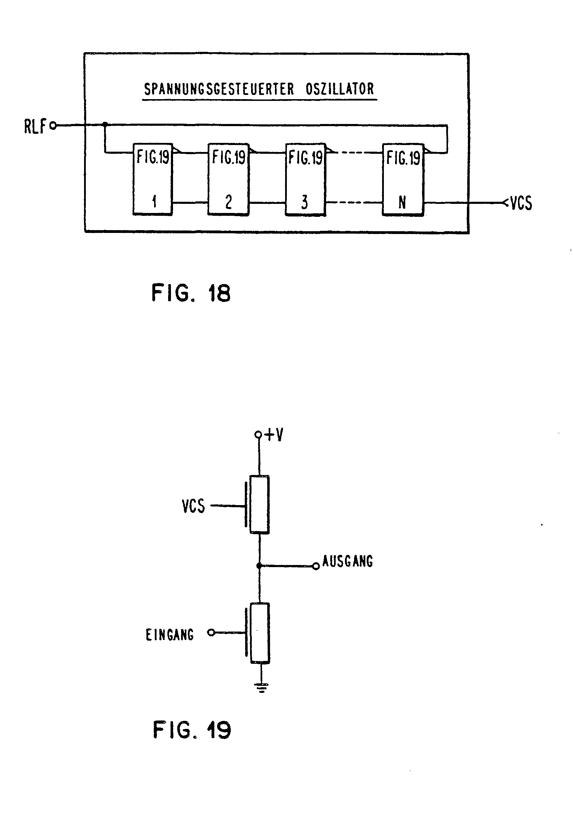

Fig. 18 zeigt die Schaltung eines spannungsgesteuerten Oszillators, der in einem Ausführungsbeispiel mit Feldeffekttransistoren verwendet werden kann. Das Eingangssignal VCS regelt die Leistung, die jedem Logik-Gatter (Fig. 19) zugeführt wird. Wie schon früher erklärt, hat eine Änderung der den Gattern des spannungsgesteuerten Oszillators zugeführten Leistung eine Frequenzänderung des Signales RLF zur Folge. Ein Erhöhen der dem Logik-Gatter (Fig. 19) zugeführten Leistung verringert die Signalverzögerung und ein Vermindern der dem Logik-Gatter zugeführten Leistung vergrößert dessen Signalverzögerung.

Im folgenden sind eine Reihe von Änderungen und Modifikationen der Erfindung aufgezählt, die vorgenommen werden können, ohne den Bereich der Erfindung zu verlassen:

1. Es ist nicht notwendig, einen Phasenregelkreis zu verwenden. Es kann ein Frequenzregelkreis verwendet werden.

2. Es ist nicht notwendig, den Systemtakt zu verwenden. Es kann ein eigener Taktgeber verwendet werden.

3. Inverter sind nicht notwendigerweise die einzige Art von Gattern, die für den spannungsgesteuerten Oszillator verwendet werden können.

4. Der Frequenzvergleich kann durch RRC-Filter und eine Spannungsvergleichsschaltung durchgeführt werden.

5. Es kann mehr als ein Regler auf einem Halbleiterchip vorhanden sein.

6. Die Pufferschaltung oder der Leistungsverstärker kann einen von 1 verschiedenen Verstärkungsfaktor haben.

7. Das Tiefpaßfilter kann sich in der Pufferschaltung befinden.

Das der Erfindung zugrundeliegende Konzept kann folgendermaßen zusammengefaßt werden:

Bei jeder Schaltung mit einer Abhängigkeit der Schaltgeschwindigkeit von der Leistung kann die Schaltgeschwindigkeit eingestellt oder geregelt werden durch Verändern der der Schaltung zugeführten Leistung.

Die Vorrichtung, durch die die Leistung variiert werden kann, wird zustandegebracht durch eine Rückkopplungsschleife, die im wesentlichen enthält das Signal eines Oszillators (, der aus den zu regelnden Gattern aufgebaut ist), ein Bezugssignal (Takt), eine Vorrichtung zum Vergleichen der Bezugs- und Oszillatorsignale, die ein Fehlersignal erzeugt und eine Vorrichtung zum Umsetzen des Fehlersignals in das geeignete Steuersignal.

Der Oszillator kann in irgendeiner Weise aus einer Reihe von Möglichkeiten, die dem Fachmann bekannt sind, aufgebaut sein. Zur Erläuterung wurde die Verwendung eines spannungsgesteuerten Oszillators beschrieben. Als Bezugssignal wurde ein Taktsignal gewählt.

Die Vergleichsschaltung, die die Funktion eines Frequenz/Spannungswandlers oder eines Frequenz/Stromwandlers erfüllt, kann irgendeine dem Fachmann bekannte Vorrichtung sein, wie ein Impulsbreitenmodulator, D-Flipflops, Digital-Analog-Umsetzer oder Phasenregelkreise. Zur Erläuterung wurde die Verwendung einer als Phasenregelkreis arbeitenden Phasenvergleichsschaltung besonders detailliert beschrieben.

**Patentansprüche**

1. Schaltung zum Angleichen der Signalverzögerungszeiten von eine Vielzahl von Logikgattern enthaltender Halbleiterchips, deren jeder eine Regelschaltung aufweist zum Ändern seiner Signalverzögerungszeit über die ihm zugeführte elektrische Leistung aufgrund eines Vergleichs der Signalverzögerungszeit von auf dem Halbleiterchip erzeugten periodischen Impulsen mit dem sehr genau definierten Intervall von dem Halbleiterchip zugeführten Taktimplusen, dadurch gekennzeichnet, daß die Regelschaltung besteht aus einer Phasenvergleichsschaltung mit zwei Eingängen und zwei Ausgängen (U, $\overline{D}$), die mit einem Tiefpaßfilter mit zwei Eingängen verbunden sind, dessen Ausgang (VCS') an einen Leistungsverstärker angeschlossen ist, der einmal mit den Logikgattern, deren Signalverzögerungszeit über die aufgenommene elektrische Leistung auf einen Sollwert gebracht werden soll, und zum anderen mit einem aus den Logikgattern gebildeten spannungsgesteuerten Oszillator verbunden ist, der zwei Ausgänge aufweist, die an eine Pegelverschiebeschaltung angeschlossen sind, deren Ausgang mit dem ersten Eingang des Phasenvergleichsschaltung verbunden ist, deren zweitern Eingang die den Sollwert der Signalverzögerungszeit bestimmenden Taktimpulse zugeleitet werden.

2. Schaltung nach Anspruch 1, dadurch gekennzeichnet, daß die Phasenvergleichsschaltung aus NOR-Gliedern aufgebaut ist.

3. Schaltung nach den Ansprüchen 1 und 2, dadurch gekennzeichnet, daß der spannungsgesteuerte Oszillator jeder Regelschaltung als Umlaufschleife aus einer ungeraden Anzahl gleicher, in Reihe geschalteter invertierender Logikgatter aufgebaut ist.

**Revendications**

1. Circuit pour l'égalisation des temps de retard de signaux d'une multiplicité de microplaquettes à semiconducteurs contenant une pluralité de portes logiques et dont chacune possède un circuit de réglage servant à modifier le temps de retard de ces signaux par l'intermédiaire de la puissance électrique, qui lui est envoyée, sur la base d'une comparaison du temps de retard des signaux formés d'impulsions périodiques produites sur la plaquette à semiconducteurs à l'intervalle, défini de façon très précise, entre des impulsions de cadence envoyées par la microplaquette à semiconducteurs, caractérisé par le fait que le circuit de réglage est constitué par un circuit comparateur de phase comportant deux entrées et deux sortie (U, $\overline{D}$), qui sont reliées par un filtre passe-bas à deux entrées et dont la sortie (VCS') est raccordée à un amplificateur de puissance qui est relié d'une part aux portes logiques, dont le temps de retard des signaux doit être réglé à une valeur de consigne par l'intermédiaire de la puissance électrique reçue, et d'autre part à un oscillateur commandé par la tension et formé par les portes logiques et qui comporte deux sorties qui sont raccordées à un circuit de décalage de niveau, dont la sortie est reliée à la première entrée du circuit comparateur de phase et à la seconde entrée duquel sont envoyées les impulsions de cadence déterminant la valeur de consigne du temps de retard des signaux.

2. Circuit selon la revendication 1, caractérisé par le fait que le circuit comparateur de phase est constitué par des circuits NON-OU.

3. Circuit selon les revendications 1 et 2, caractérisé par le fait que l'oscillateur commandé par la tension de chaque circuit de réglage est constitué sous la forme d'une boucle à circulation constituée par un nombre impair de portes logiques inverseuses identiques branchées en série.

**Claims**

1. Circuit for adapting the signal delay times of semiconductor chips comprising a plurality of logic gates, each chip having a control circuit for altering its signal delay time via the electric power applied thereto, on the basis of a comparison of a signal delay time of periodic pulses generated on the semiconductor chip with the very precisely defined interval of clock pulses applied to the semiconductor chip, characterized in that the control circuit consists of a phase compare circuit having two inputs and two outputs (U, $\overline{D}$) connected with a low path filter having two inputs whose output (VCS') is connected to a power amplifier which is connected, on the one hand to the logic gates whose signal delay time is to be adjusted at a nominal value via the electric power received, and on the other to a voltage-controlled oscillator formed of the logic gates and having two outputs which are connected to a level shift circuit whose output is connected to the first input of the phase compare circuit to whose second input the clock pulses determining the nominal value of the signal delay time are applied.

2. Circuit as claimed in claim 1, characterized in that the phase compare circuit is structured of NOR-gates.

3. Circuit as claimed in claims 1 and 2, characterized in that the voltage control oscillator of each control circuit is structured as a circulation loop consisting of an odd number of equal, series-arranged inverting logic gates.

13

FIG. 1

FIG. 2

HALBLEITERCHIP 1

FIG. 10

FIG. 10

FIG. 10

TAKT

4

SIGNALVERZÖGERUNGS-
REGLER
(FIG. 4)

VCS 1

HALBLEITERCHIP n

FIG. 10

FIG 10

FIG 10

4

SIGNALVERZÖGERUNGS-
REGLER
(FIG. 4)

VCSn

FIG. 3

FIG. 10

FIG 10

| TAKT | Ø VERGLEICHS-SCHALTUNG (FIG. 5) | U | | |
|---|---|---|---|---|
| | | D̄ | TIEFPASSFILTER (FIG. 6) | VCS' |

PUFFER (LEISTUNGS-VERSTÄRKER) (FIG. 7)

VCS

PEGELVERSCHOBENES SIGNAL

| PEGELVERSCHIEBUNGS-SCHALTUNG (FIG. 9) | RLF | SPANNUNGSGESTEUERTER OSZILLATOR (FIG 8) |
|---|---|---|
| | VR | |

FIG. 4

FIG. 4A

FIG. 5

VP

TE

TA

VREF
(FIG. 9,12)

TB

TC

TD

BEZUGSSPANNUNGS-
GENERATOR

FIG. 11

U
(FIG. 5)

D̄
(FIG. 5)

VCS'
(FIG. 7)

TIEFPASSFILTER

FIG. 6

RLF
(FIG. 9)

VR
(FIG. 9)

| 1 FIG.10 | 2 FIG 10 | | N-1 | N FIG 10 |

VCS
(FIG 7)

SPANNUNGSGESTEUERTER
OSZILLATOR

FIG. 8

**0 046 482**

TYPISCHES GATTER

FIG. 10

PUFFER (LEISTUNGSVERSTÄRKER)

FIG. 7

7

VP

PEGELVERSCHOBENES
SIGNAL

K

J

H

RLF
(FIG. 8)

TA    TB

VR
(FIG. 8)

VREF

FIG. 11

G

TC

TF

D

E

PEGELVERSCHIEBUNGSSCHALTUNG

## FIG. 9

VP

$\bar{0}$

0

EINGANG 1

EING. 2

VREF

FIG. 11

TA

TB

TC

INTERNES GATTER

## FIG. 12

SPANNUNGSGESTEUERTER OSZILLATOR

FIG 14 1  FIG.14 2  FIG.14 3  ---  FIG.14 N

RLF

VCS

**FIG. 13**

VCS

**FIG. 14**

SPANNUNGSGESTEUERTER OSZILLATOR

FIG.16 17 1  FIG.16 17 2  FIG.16 17 3  ---  FIG.16 17 4

RLF

**FIG. 15**

WIDERSTAND
AUF DEM / AUSSERHALB
VOM HALBLEITERCHIP

VCC

B

ZU DEN
SCHALTUNGEN AUF
DEM HALB-
LEITERCHIP

TA

AUSG.

EING.

VCS

**FIG. 16**

WIDERSTAND
AUF DEM / AUSSERHALB
VOM HALBLEITERCHIP

VCS

B

VCS*

ZU DEN
SCHALTUNGEN
AUF DEM HALBLEITERCHIP

TA

AUSG

EING

**FIG. 17**

SPANNUNGSGESTEUERTER OSZILLATOR

RLF

FIG.19 1  FIG.19 2  FIG.19 3  ---  FIG.19 N

<VCS

FIG. 18

+V

VCS

AUSGANG

EINGANG

FIG. 19